**Europäisches Patentamt**

**European Patent Office**

**Office européen des brevets**

(11) Veröffentlichungsnummer: **0 456 893 A2**

# EUROPÄISCHE PATENTANMELDUNG

(21) Anmeldenummer: **90122921.1**

(22) Anmeldetag: **30.11.90**

(51) Int. Cl.5: **H03M 7/42**

(30) Priorität: **14.05.90 DE 4015420**

(43) Veröffentlichungstag der Anmeldung:
**21.11.91 Patentblatt 91/47**

(84) Benannte Vertragsstaaten:
**AT DE FR GB IT NL SE**

(71) Anmelder: **ROBERT BOSCH GmbH**
**Postfach 10 60 50**
**W-7000 Stuttgart 10(DE)**

(72) Erfinder: **Schwarz, Gottlieb, Dipl.-Ing.**
**Plantage 16**
**W-1000 Berlin 20(DE)**

(74) Vertreter: **Schmidt, Hans-Ekhardt, Dipl.-Ing.**
**Robert Bosch GmbH Geschäftsbereich**
**Mobile Kommunikation Patent- und**
**Lizenzabteilung Forckenbeckstrasse 9-13**
**W-1000 Berlin 33(DE)**

(54) **Verfahren zur Datenkompression.**

(57)

2.1 Bekannte Verfahren verwenden verschiedene Algorithmen zur Datenkompression.

2.2 Das erfindungsgemäße Verfahren zur Datenkompression von nach einer Codierungsvorschrift codierter Zeichen konstanter Wortlänge verwendet das höchstwertige Bit des Zeichens zur Steuerung der Datenkompression.

2.3 Das erfindungsgemäße Verfahren ist vorteilhaft einsetzbar bei codierten Zeichen mit konstanter Wortlänge.

Die Erfindung betrifft ein Verfahren zur Datenkompression nach dem Oberbegriff des Anspruchs 1.

Bei der Verwendung eines Rechners mit einer Datenwortlänge von 8 Bit werden Textzeichen, die beispielsweise in ASCII codiert sind, einem Datenwort zugeordnet. Diese Information ist jedoch redundant, da nicht alle Zeichen mit gleicher Wahrscheinlichkeit auftreten.

Bei der ASCII-Codierung wird jedoch eine eindeutige Zuordnung aller gebräuchlichen alphanumerischen Zeichen schon mit 7-Bit erreicht. Es werden also bei einer Datenübertragung von üblichen Texten mit 8 Bit-Datenworten redundante Bits übertragen und somit die Übertragungszeit bzw. Belegung eines Nachrichtenkanals unnötig vergrößert.

In der Zeitschrift "MC, Die Mikrocomputerzeitschrift", 6/1989, Seiten 74 bis 79, sind beispielsweise Datenkompressionsmethoden beschrieben, die u.a. nach dem Huffmanschen Algorithmus eine Datenkompression durchführen. Bei diesem Verfahren wird der Umfang eines zu übertragenden Datenfiles auf etwa die Hälfte reduziert. Nachteilig bei diesen Verfahren ist jedoch der hohe Aufwand und die mangelnde Kompatibilität mit üblichen 8-Bit-Systemen.

Ein anderes bekanntes Datenkompressionsverfahren ist das Radix-40-Verfahren. Dieses Verfahren codiert drei Zeichen aus einer 40 Zeichen umfassenden Tabelle in zwei 8 Bit-Datenworten und reduziert den Umfang einer Datenfile auf etwa zwei Drittel.

Der Erfindung liegt die Aufgabe zugrunde, ein Verfahren zur Datenkompression anzugeben, welches eine hohe Datenkompression für Datenübertragung und -aufzeichnung erlaubt.

Diese Aufgabe wird bei einem Verfahren zur Datenkompression nach dem Oberbegriff des Anspruchs 1 durch die im Kennzeichen angegebenen Merkmale gelöst.

Vorteilhafte Weiterbildungen der Erfindung sind in den Unteransprüchen gekennzeichnet bzw. werden nachstehend zusammen mit der Beschreibung der bevorzugten Ausführung der Erfindung näher dargestellt.

Erfindungsgemäß wird dazu das redundante 8. Bit eines Datenwortes, welches insbesondere nach ASCII codiert ist, zur Steuerung einer Datenkompression ausgenutzt.

Das erfindungsgemäße Verfahren beruht auf der Erkenntnis, daß ein in der üblichen 8-Bit-Datenübertragung nur in Sonderfällen benutztes 8. Datenbit eine Entscheidungsinformation dahingehend beinhalten kann, daß die Restinformation des Datenwortes nicht ein übliches alphanumerisches Zeichen codiert enthält, sondern zusammen mit einem oder mehreren Datenworten, die vorzugsweise unmittelbar nachfolgen, ein vollständiges Wort innerhalb eines ein Wörterbuch enthaltenden Speichers bezeichnet. Bei einem ein Wörterbuch bildenden Speicher wird der Umstand ausgenutzt, daß hier die zu erwartenden Textworte der Umgangs- oder jeweiligen Fachsprache informationsmäßig "dicht gepackt" angeordnet sind, daß heißt jede mögliche aus mindestens zwei Datenworten bestehende Informationseinheit genau ein Sprachwort bezeichnet. Auf diese Weise läßt sich mit wenigen Bit ein Sprachwort bezeichnen - und damit übertragen, wenn berücksichtigt wird, daß der übliche Wortschatz einer Sprache aus wenigen tausend Worten besteht. Es ist ersichtlich, daß mit den Mitteln der Erfindung auch Fachbegriffe oder sonstige komplexe Informationseinheiten mit geringem Bedarf von Kanalkapazität oder Speicher übertragen bzw. festgehalten werden können.

Das erfindungsgemäße Verfahren ist insbesondere auch günstig anwendbar für die Übertragung in fremde Sprachen, da in diesem Fall lediglich der das "Wörterbuch" bildende Speicher ausgetauscht zu werden braucht.

Bei einer vorteilhaften Weiterbildung der Erfindung zur Anwendung bei der Datenkompression, vorzugsweise für die Übertragung und/oder Speicherung von Texten wird das redundante höchstwertige Bit, im folgenden "erstes Bit" genannt, folgendermaßen verwendet:

1. Ist das 1. Bit eine "0", dann stellen die folgenden m Bit ein nach einer Codiervorschrift codiertes Zeichen, z. B. ein ASCII-Zeichen, dar, wobei $m = 7$ ist.

2. Ist das 1. Bit eine "1", dann stellen die folgenden n Bit ein codiertes Wort aus einer maximal $2^n-1$ Wörtern umfassende Codetabelle, insbesondere ein Wörterbuch dar. Für $n = 15$ ergibt sich somit eine Codetabelle mit maximal 32.767 Wörtern, wobei jedes Wort eine Zeichenfolge beliebiger Zeichenanzahl darstellt.

Zur Durchführung des erfindungsgemäßen Verfahrens ist eine Codetabelle mit maximal $2^n-1$ Wörtern zu erstellen. Jedem Wort ist eine Zeichenfolge beliebiger Zeichenanzahl zugeordnet, wobei jedes Wort mit n Bit codiert ist. Ein solche Codetabelle kann z. B. die häufigsten benötigten Worte in Form eines Wörterbuches enthalten, insbesondere für spezielle Fachgebiete.

Zur weiteren Datenreduktion kann in einer weiteren Ausgestaltung des Verfahrens die Tatsache ausgenutzt werden, daß in einem Text Wörter durch Leerzeichen getrennt sind. Diese Leerzeichen sind nach der Codierung der Wörter redundant und werden z.B. vor der Übertragung durch einen Coder eines Senders entfernt. Ein entsprechender Decoder eines Empfängers fügt beim Empfang zweier codierter Wörter automatisch wieder Leerzeichen zu. Gleiches gilt bei Sonderzeichen gefolgt von einem codierten Wort.

Weiterhin können Sonderzeichen eines Textes ausgenutzt werden. Im Text werden Sätze durch ein Sonderzeichen, z.B. einem Punkt, abgeschlossen. Das erste Wort des nächsten Satzes beginnt dann mit einem Großbuchstaben. Der Empfänger kann vorteilhaft den Datenstrom auf das Auftreten eines Sonderzeichens überwachen und nach Empfang des Sonderzeichens den ersten Buchstaben eines folgenden codierten Wortes automatisch in einen Großbuchstaben wandeln. Diese Überwachungsfunktion ermöglicht eine zusätzliche Empfangssicherheit und Korrekturmöglichkeit.

Ein besonderer Vorteil des erfindungsgemäßen Verfahrens ist in einer Datenkompression auf Wortbasis mit einer konstanten Wortlänge, also mit Bytegrenzen, und die Möglichkeit einer transparenten nichtkomprimierten Zeichenübertragung des nach der Codiervorschrift codierten Zeichens zu sehen. Ein weiterer Vorteil ist die Entfernung von Leerzeichen zwischen den codierten Wörtern vor der Übertragung.

Ausgehend von einer asynchronen Datenübertragung, beispielsweise von ASCII-codierten Zeichen mit einem Start-, einem Stopp- und acht Datenbits und dem erfindüngsgemäßen Verfahren, ist eine 3 bis 5-fache Erhöhung der Übertragungsrate bei einer codierten Wortübertragung mit einer durchschnittlichen Zeichenanzahl von 5 bis 7 Zeichen je Wort möglich.

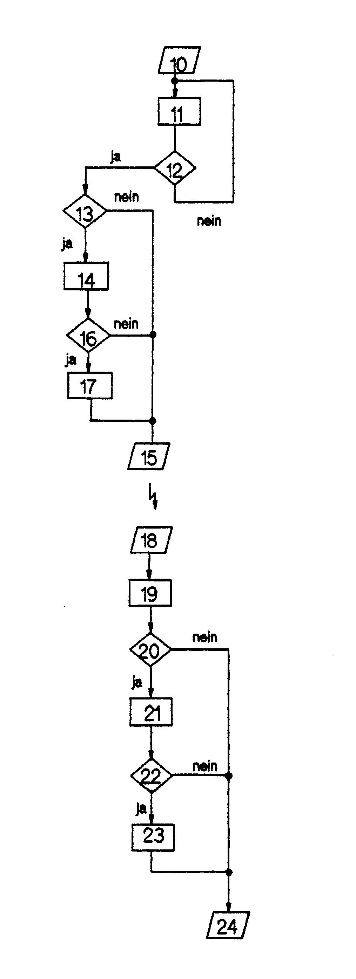

Nachfolgend wird die Erfindung anhand der Zeichnung näher erläutert.

Die Zeichnung zeigt ein Ausführungsbeispiel anhand eines Flußdiagramms. Über eine Eingabeeinrichtung 10 werden zu Beginn der Übertragung Zeichen in einen Puffer 11 eingegeben. Nach der Eingabe wird in einem Entscheider 12 abgefragt, ob es sich bei dem Zeichen um eine Leerstelle oder ein Sonderzeichen handelt. Sobald ein solches Zeichen eingegeben worden ist, wird in einem Vergleicher 13 abgefragt, ob die bisher eingegebene Zeichenfolge in einer Codetabelle 14 enthalten sind. Ist dies nicht der Fall, werden die Zeichen aus dem Puffer im ASCII-Code an eine Ausgabeeinrichtung 15 übertragen. Das erste Bit eines jeden 8-Bit-Datenwortes der eingegebenen Zeichenfolge ist dann "0". Wird durch den Vergleicher 13 ein codiertes Datenwort in einer Codetabelle 14 gefunden, ersetzt ein Coder die eingegebene Zeichenfolge durch das codierte Datenwort. Das erste Bit ist dann "1". Anstelle der eingegbenen Zeichenfolge mit variabler Länge entspechend der Eingabe wird ein codiertes Wort konstanter Länge übertragen, welches im Mittel deutlich weniger Bits enthält als die eingegebene Zeichenfolge.

In einem weiteren Vergleicher 16 wird abgefragt, ob beispielsweise zwei codierte Worte aufeinanderfolgen. Ist dies nicht der Fall, wird das Codewort der Ausgabeeinrichtung 15 zugeführt. Im Falle eines positiven Vergleichs kann vorteilhaft in einer Unterdrückungsschaltung 17 das zwischen ihnen enthaltene Zeichen, welches einer Leerstelle entspricht, für die Übertragung eleminiert werden. Gleiches gilt entsprechend für Leerzeichen zwischen Sonderzeichen gefolgt von einem codierten Wort oder ASCII-Zeichen.

Auf der Empfängerseite werden die eingehenden Datenworte in einer Empfangseinrichtung 18 aufgenommen und in einem Puffer 19 gespeichert. Die gespeicherten Zeichenfolgen werden auf das 1. Bit des empfangenen Wortes in einem Entscheider 20 hin auf eine mögliche Kompression untersucht. Wenn das erste Bit eine "0" ist, erkennt der Empfänger, daß keine Codierung stattgefunden hat. Das Zeichen wird so, wie es empfangen wurde, einer Verarbeitungeinrichtung 24 zugeführt. Ist hingegen das erste Bit eine "1", wird der aus einer Codetabelle 21 die dem Codewort entsprechende Zeichenfolge entnommen und das Codewort durch diese ersetzen.

In einem weiteren Entscheider 22 wird überprüft, ob zwei Codeworte oder ein Sonderzeichen und ein Codewort oder ASCII-Zeichen aufeinanderfolgen. Bei positiver Entscheidung fügt eine Einfügeeinrichtung 23 des Empfängers ein Leerzeichen ein, anderenfall wird die Zeichenfolge der Verarbeitungeinrichtung 24 zugeführt. Vorteilhaft kann im Empfänger nach Empfang eines Sonderzeichens, wie beispielsweise einem Satzendezeichens, das erste Zeichen folgenden aus einem Codewort decodierten Zeichenfolge in einen Großbuchstaben gewandelt werden.

Die Erfindung ist nicht beschränkt auf Zeichenfolgen, die mit einem Sonderzeichen oder einer Leerstelle abgeschlossen sind. Die Codetabelle kann auch häufig Worfbestandteile enthalten, die dann durch das erfindungsgemäße Verfahren codiert werden können.

Die Erfindung beschränkt sich in ihrer Ausführung nicht auf das vorstehend angegebene bevorzugte Ausführungsbeispiel. Vielmehr ist eine Anzahl von Varianten denkbar, welche von der dargestellten Lösung auch bei grundsätzlich anders gearteten Ausführungen Gebrauch macht.

**Patentansprüche**

1. Verfahren zur Datenkompression nach einer Codierungsvorschrift mit codierten Zeichen vorbestimmter Datenwortlänge für Übertragung und/oder Aufzeichnung,

   **dadurch gekennzeichnet,**

   daß ein einzelnes oder wenige Bits des jeweiligen Datenwortes jeweils ein Entscheidungskriterium dahingehend bilden, ob die restlichen Bits des Zeichens oder diese und ein bzw. mehrere weitere Datenworte eine gemeinsam mittels einer Tabelle zu decodierende Informationseinheit bilden.

2. Verfahren nach Anspruch 1, **dadurch gekennzeichnet,** daß bei einem höchstwertigen Bit = "0" des Zeichens die folgenden m Bit ein nach der Codierungsvorschrift codiertes Zeichen und daß bei einem höchstwertigen Bit = "1" die folgenden n Bit ein Codewort aus einem maximal 2expn-1 Wörtern umfassende Codetabelle darstellen.

3. Verfahren nach Anspruch 2, **dadurch gekennzeichnet,** daß die Codetabelle maximal 2expn-1 Codewörter enthält und daß jedem Codewort eine Zeichenfolge beliebiger Zeichenanzahl zugeordnet ist.

4. Verfahren nach einem oder mehreren der Ansprüche 1 bis 3, **dadurch gekennzeichnet,** daß die Zeichen alphanumerische Zeichen sind.

5. Verfahren nach Anspruch 4, **dadurch gekennzeichnet,** daß der ASCII-Code die Codierungsvorschrift für die restlichen Zeichen des Datenworts und ein Wörterverzeichnis die Codierungsvorschrift für die aus den restlichen Zeichen des Datenworts und mindestens einem weiteren Datenwort bestehende Informationseinheit bildet.

6. Verfahren nach Anspruch 5, **dadurch gekennzeichnet,** daß bei Aufeinanderfolgen von zwei Codeworten und/oder einem Sonderzeichen und einem Codewort oder ASCII-Zeichen die dazwischen eingefügte Leerstelle vor der Übertragung entfernt und nach Empfang wieder eingefügt wird.

7. Verfahren nach einem der Ansprüche 3 bis 6, **dadurch gekennzeichnet,** daß nach Auftreten eines Satzendezeichens der erste Buchstabe einer folgenden aus einem Codewort decodierten Zeichenfolge in einen Großbuchstaben gewandelt wird.